Europäisches Patentamt

European Patent Office

Office européen des brevets

(19)

(11) Veröffentlichungsnummer : **0 141 041**
**B1**

(12)

# EUROPÄISCHE PATENTSCHRIFT

(45) Veröffentlichungstag der Patentschrift :
03.01.90

(21) Anmeldenummer : 84108269.6

(22) Anmeldetag : 13.07.84

(51) Int. Cl.⁵ : $H\ 01\ J\ 35/00$, $G\ 03\ F\ 7/20$

(54) **Röntgenlithographiegerät.**

(30) Priorität : 26.08.83 DE 8324545 U

(43) Veröffentlichungstag der Anmeldung :
15.05.85 Patentblatt 85/20

(45) Bekanntmachung des Hinweises auf die Patenterteilung : 03.01.90 Patentblatt 90/01

(84) Benannte Vertragsstaaten :
AT BE CH DE FR GB IT LI LU NL SE

(56) Entgegenhaltungen :
DE–A– 3 117 726
GB–A– 2 012 452
AUTOMATIC WELDING,Nr. 10, Oktober 1969, Seiten 39-43, Cambridge, GB; G.S.KRYSHTAB et al.: "Electron beam microwelding and microtreatment"
ELECTRO MEDICA, Nr. 1, 1982, Seiten 6-10, Enlagen, DE; V.E.GELDNER et al.: "IEC publikation 336/1981 - Neufassung der Norm für Röntgenbrennflecke"

(73) Patentinhaber : feinfocus Verwaltungs GmbH & Co. KG
Hagenburger Strasse 8A
D-3050 Wunstorf 1 (DE)

(72) Erfinder : Reinhold, Alfred
Opferkamp 1
D-3050 Wunstorf 1 (DE)

(74) Vertreter : Junius, Walther, Dr.
Wolfstrasse 24
D-3000 Hannover 81 (DE)

## Beschreibung

Die Erfindung betrifft ein Röntgenlithographiegerät, bestehend aus einer Möntgenröhre mit mindestens einem Austrittsfenster zur Erzeugung einer langwelligen Röntgenstrahlung, die eine aus Glühkathode und Gitter bestehende Elektronenkanone, eine Elektronenstrahlablenk- und -bündelungsvorrichtung, ein Target aus einem Material hoher Ordnungszahl und hohen Schmelzpunktes aufweist, aus einem Träger für das mit Röntgenstrahlen zu belichtende Substrat sowie aus einem Träger für die Lithographiemaske.

Derartige Geräte sind aus der DE-A-28 54 693 sowie der GB-A-2 012 452 bekannt.

Eingesetzt werden diese Lithographiegeräte bei der Herstellung von integrierten Schaltungen, insbesondere hochintegrierten und höchstintegrierten Schaltungen. Aus theoretischen Überlegungen eignen sich Röntgenstrahlen besonders gut, um feinste Strukturen im Submikrometerbereich scharf abzubilden. In der Praxis haben aber noch nicht Geräte hergestellt werden können, die sicher und zuverlässig die erforderlichen scharfen Abbildungen in Lithographiegeräten durchführen konnten. Daher konnten Röntgenlithographiegeräte die mit Licht arbeitenden Lithographiegeräte nicht aus dem Markt drängen, obwohl die mit Licht arbeitenden Lithographiegeräte sehr gewichtige Nachteile aufweisen, die vor allem in einer sehr langen Belichtungsdauer bestehen.

Weil harte Röntgenstrahlen die Lithographiemasken praktisch ungehindert durchqueren können, ist es für die Herstellung von kontrastreichen Abbildungen erforderlich, weiche Röntgenstrahlen zu verwenden, die mit Spannungen von drei bis 25 KV erzeugt werden. Bei weichen Röntgen(brems-)strahlen ist aber der Wirkungsgrad der Röntgenstrahlausbeute extrem gering. Das führt zu langen Belichtungszeiten.

Die vorliegende Erfindung geht von der Erkenntnis aus, daß für ein leistungsfähiges Röntgenlithographiegerät sowohl eine besondere Kathode zu verwenden ist als auch Maßnahmen vor dem Target vorzusehen sind, um effektiv und ökonomisch die benötigte langwellige Röntgenstrahlung zu erzeugen, als auch am Target selbst und hinter dem Target Maßnahmen für eine effektive Bestrahlung und eine ökonomische Ausnutzung der Bestrahlungszeiten notwendig sind.

Von Elektronenkanonen für Elektronenstrahlschweißen ist es aus der Literaturstelle Automatic Welding 1969, Seite 39-43, bekannt, als Gitter einen Wehneltzylinder zu benutzen, bei dem die dem Target zugewandte Seite unter einem Winkel trichterförmig auf die Spitze der Glühkathode zu verläuft. Mit einer derartigen Elektronenkanone kann ein sehr kleiner Brennfleck erreicht werden.

Es ist die Aufgabe der Erfindung, ein leistungsfähiges Röntgenlithographiegerät zu erzeugen, welches mit geringem Energieaufwand bei einfacher Bauart so ausreichend langwellige Röntgenstrahlung erzeugt, daß relativ kurze Belichtungszeiten ermöglicht werden, und welches sich durch hohe Wirtschaftlichkeit auszeichnet.

Die Erfindung besteht darin, daß eine Elektronenkanone, bei der das Gitter auf seiner dem Target zugewandten Seite einen nach innen gerichteten Flansch aufweist, der die Öffnung, in der sich die Spitze der Glühkathode befindet, umschließt, bei der die der Glühkathode zugewandte Seite des Flansches eben ist oder in Richtung auf die Glühkathode abgewinkelt ist, bei der die dem Target zugewandte Seite des Flansches unter einem Winkel β von 100° bis 140° in Richtung auf die Spitze der Glühkathode zu verläuft und bei der sich das Material des Flansches in Richtung auf den die zentrische Öffnung begrenzenden Rand unter einem Winkel α von 15 bis 60° verjüngt, in der Röntgenröhre verwendet wird, daß der Brennfleck auf dem Target einen Durchmesser von weniger als $10^{-4}$ m aufweist, daß der Abstand zwischen dem Target und dem Röntgenstrahlenaustrittsfenster der Röntgenröhre maximal $2 \cdot 10^{-2}$ m beträgt und daß der Abstand zwischen Target und Lithographiemaske maximal $2 \cdot 10^{-1}$ m beträgt, daß die Oberfläche des Targets aus einer gewölbten oder mindestens zwei, durch eine Kante voneinander getrennten winklig zueinander angeordneten ebenen Flächen besteht, daß ein Teil der gewölbten Fläche oder die eine ebene Fläche dem Röntgenstrahlenaustrittsfenster zugewandt und der andere Teil der gewölbten Fläche oder die andere ebene Fläche dem Röntgenstrahlenaustrittsfenster abgewandt ist, daß man für die durch jedes Austrittsfenster der Röntgenröhre austretenden Strahlen den Targetwinkel so wählt, daß er zwischen 0 und 10°, vorzugsweise bei 5,5°, liegt und daß eine Steuervorrichtung für die in die Ablenkvorrichtung eingespeisten Spannungen vorgesehen ist, mit der der Elektronenstrom bei der Wanderung von einem Abstrahlpunkt auf einen anderen Abstrahlpunkt zweimal über den der Elektronenkanone zugewandten Zenit oder eine der Elektronenkanone zugewandte Kante auf dem Target abgelenkt wird.

Die hier verwendete Elektronenkanone erzeugt auf einem besonders kleinen Fokus einen besonders intensiven Elektronenstrom, der schon infolge des kleinen Fokus in sich gut gebündelt ist, durch Elektronenstrahlbündelungsvorrichtungen jedoch noch weiter gebündelt werden kann, so daß auf dem Target ein besonders kleiner Brennfleck entsteht, der jedoch, da Beschleunigungsspannungen von 3 KV bis 25 KV verwendet werden, in diesem kleinen Brennfleck eine sehr intensive langwellige Röntgenstrahlung erzeugt.

Durch einen so kleinen Brennfleck auf dem Target wird naturgemäß das Target stark belastet. Daher ist das Target bei der Erfindung in der beschriebenen besonderen Weise gestaltet, um das Target nicht überzubelasten und dem Target eine lange Lebensdauer zu geben. Bei der Erfindung wird der Elektronenstrom bei der Wanderung von einem Abstrahlpunkt auf einen anderen Abstrahlpunkt zweimal über den der Elektronenkanone zugewandten Zenit oder eine der Elektronenkanone zugewandte Kante auf dem Target abgelenkt. Hierdurch wird ein ständiger Brennfleckwechsel erreicht, nämlich ein Arbeiten im Impulsbetrieb der Röntgenröhre, wobei jedoch die Röntgenröhre ständig im Betrieb bleibt, so daß nicht Nachteile durch Ein- und Abschalten des Elektronenstromes auftreten können.

In diesem Impulsbetrieb ist es zweckmäßig, wenn die Steuervorrichtung den Auftreffpunkt des Elektronenstrahles auf einem Abstrahlpunkt verharren läßt und dann den Elektronenstrahl mit hoher Geschwindigkeit auf den nächsten Abstrahlpunkt bewegt und ihn dort wieder verharren läßt, weil dann diejenigen Zeiten, in denen der emittierte Elektronenstrom genutzt wird, groß sind gegenüber denjenigen Zeiten, in denen der Elektronenstrom nicht genutzt wird.

Besondere wirkungsvoll für die Ausnutzung des Elektronenstromesist es jedoch, wenn die Röntgenröhre auf mindestens zwei gegenüberliegenden Seiten je ein Röntgenstrahlenaustrittsfenster aufweist, zwischen denen das Target angeordnet ist, wenn die Oberfläche des Targets aus einer gewölbten Fläche mit der Elektronenkanone zugewandten Zenit oder aus mindestens zwei ebenen, durch mindestens eine Kante voneinander getrennten, winklig zueinander angeordneten ebenen Flächen besteht, wenn beidseits des Zenits je ein Teil der gewölbten Fläche oder beidseits der Kante je eine ebene Fläche je einem Röntgenaustrittsfenster zugewandt ist, wenn man für die durch jedes Austrittsfenster der Röntgenröhre austretenden Strahlen den Targetwinkel so wählt, daß er zwischen 0 und 10°, vorzugsweise bei 5,5° liegt, und wenn eine Steuervorrichtung für die in die Ablenkvorrichtung eingespeisten Spannungen vorgesehen ist, mit der der Elektronenstrom bei der Wanderung von einem Abstrahlpunkt auf einer Fläche (bzw. Flächenteil) auf einen anderen Abstrahlpunkt auf der anderen Fläche (bzw. Flächenteil) über den Zenit oder die Kante abgelenkt wird. Hierdurch wird ein Röntgenlithographiegerät geschaffen, welches zu beiden Seiten der Röntgenröhre Träger für Lithographiemasken und Träger für das zu belichtende Substrat aufweist. Abwechselnd wird hier einmal das zur einen Seite, dann anschießend das zur anderen Seite angeordnete Substrat bestrahlt, so daß der Elektronenstrom der Röntgenröhre ständig ausgenutzt wird. Aber nicht nur die ständige Ausnutzung des Elektronnenstromes der Röntgenröhre ist hier ein besonderer Vorteil, sondern es besteht auch der weitere Vorteil, daß in derjenigen Zeit, in der das eine Substrat nicht bestrahlt wird, dieses Substrat gegen ein völlig unbestrahltes Substrat ausgewechselt werden kann. Während der Auswechselungszeit wird somit das auf der anderen Seite angeordnete Substrat bestrahlt.

Das Wesen der Erfindung ist nachstehend anhand von in der Zeichnung schematisch dargestellten Ausführungsbeispielen näher erläutert. Es zeigen :

Fig. 1 einen Querschnitt durch eine Elektronenkanone mit sehr kleinem Emissionsfleck und hoher Elektronenemission,

Fig. 2 einen Querschnitt durch die Lithographieorrichtung,

Fig. 3 einen Querschnitt durch die Röntgenröhre im Bereich des Targets,

Fig. 4 einen Querschnitt durch eine Röntgenlithographievorrichtung für die wechselseitige Bestrahlung zweier Substrate,

Fig. 5 einen Querschnitt durch die Röntgenröhre im Bereich des Targets der Vorrichtung nach Fig. 4,

Fig. 6 einen Schnitt durch die Röntgenröhre der Fig. 4, unterhalb des Targets mit einer Darstellung der Brennflecke auf dem Target,

Fig. 7 eine perspektivische Ansicht eines halbkugelförmigen Targets,

Fig. 8 eine perspektivische Ansicht eines pyramidenstumpfförmigen Targets,

Fig. 9 eine schematische Darstellung der Anordnung der zu bestrahlenden Substrate um die Röntgenröhre.

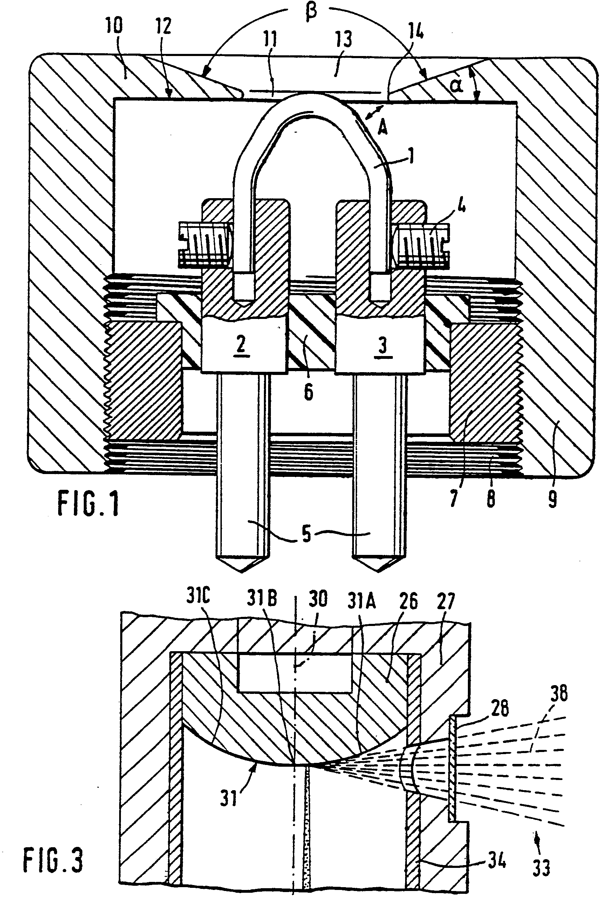

Für die vorliegende Erfindung ist von hoher Wichtigkeit, daß eine Elektronenkanone mit einer Glühkathode Verwendung findet, deren Elektronenaustrittsstelle einen möglichst kleinen Durchmesser aufweist. Eine solche Elektronenkanone ist in der Fig. 1 dargestellt :

Der U-förmig gebogene Heizfaden 1 der Glühkathode ist mit seinen beiden Schenkeln in Klemmvorrichtungen 2,3 mittels der Schrauben 4 geklemmt. Die Klemmvorrichtungen 2,3 laufen in Stecker 5 aus, die an eine elektrische Stromquelle angeschlossen werden. Die beiden Klemmvorrichtungen 2,3 sind in eine Isolierscheibe 6 eingesetzt, die von einem Ring 7 getragen wird, der auf seiner Außenseite ein Außengewinde trägt, auf das das Innengewinde des topfförmigen Gitters 9 geschraubt ist. Hierdurch bilden Gitter 9 und die Glühkathode eine Baueinheit, die mittels der Stecker 5 auf einen Sockel steckbar ist. Dabei kann die Stellung des Gitters 9 gegenüber der Glühkathode 1 verändert werden. Das Gitter 9 weist einen zylindrischen Teil auf, welcher das Innengewinde an einem Ende trägt und welcher am anderen, dem nicht dargestellten Target der Röntgenröhre zugewandten Ende einen nach innen gerichteten Flansch 10 als nach innen gerichteten Vorsprung trägt. Zentrisch in diesem Flansch befindet sich die Öffnung 11, welche die Spitze des als Glühkathode dienenden Glühdrahtes 1 umgibt. Die der Glühkathode 1 zugewandte Seite 12 dieses Flansches ist entweder eben (Fig. 1) oder in Richtung auf die Glühkathode 1 abgewinkelt, wobei die Abwinkelungsstelle auch direkt an dem Übergang der Fläche 12 in die Innenwandung des zylindrischen Teiles des Gitters 9 befindlich sein kann, so daß hier der Winkel zwischen der Innenseite des zylindrischen Teiles des Gitters 9 und der Fläche 12 weniger als 90° beträgt. Die Außenseite des Flansches ist konisch bzw. trichterförmig gestaltet, derart, daß sich der Flansch 10 in Richtung auf die Öffnung 11 verjüngt. Das Zentrum dieser trichterförmigen Fläche 13 befindet sich in der Spitze des Glühdrahtes 1 oder dicht unterhalb der Spitze des Glühdrahtes 1. Die Fläche 12 ist ebenfalls auf die Spitze des Glühdrahtes 1 oder einen Punkt dicht unterhalb der Spitze des Glühdrahtes 1 gerichtet. Die Kante des Randes 14, also der Übergangsstelle von der trichterförmigen Fläche 13 in die Fläche 12 ist abgerundet, und zwar im Querschnitt in etwa halbkreisförmig gestaltet. Der Durchmesser dieses Halbkreises ist klein.

Der Durchmesser des Glühfadens wird zweckmäßigerweise mit 0,2 bis 0,4 mm gewählt, der Abstand A von dem Rand 14 des Flansches 10 des Gitters 9 vor der am nächsten liegenden Stelle des Glühfadens 1 wird zweckmäßigerweise 0,4 bis 4 mm gewählt. Der Winkel α, das ist der von der konischen Fläche 13 und der Innenfläche 12 des Flansches eingeschlossene Winkel wird zweckmäßigerweise 15 bis 60° gewählt, während der Winkel ß, das ist der Konuswinkel bzw. Trichterwinkel der konischen Fläche 13 wird zweckmäßigerweise mit 100 bis 140° gewählt.

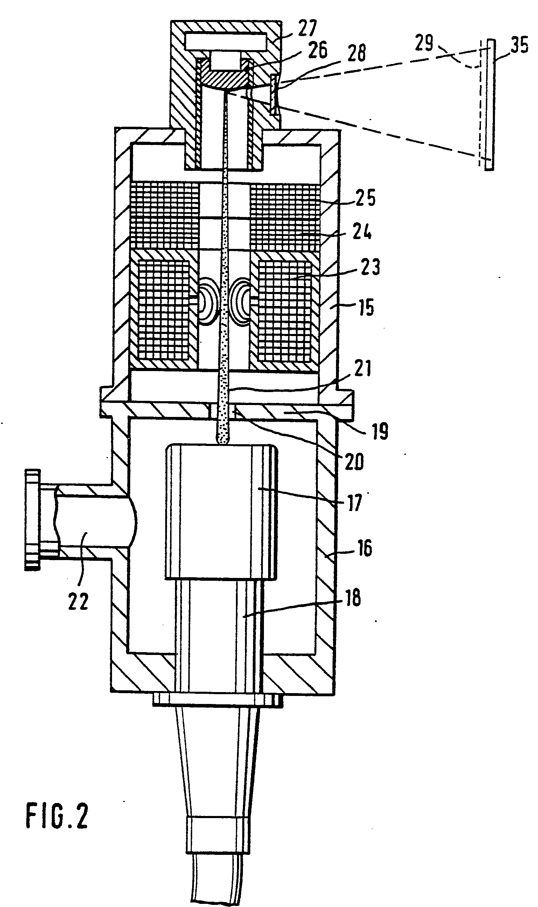

Die Röntgenlithographievorrichtung ist in Fig. 2 dargestellt. Sie besteht aus einer Röntgenröhre mit dem Gehäuse 15, 16, in welchem die Elektronenkanone 17 eingebaut ist, die im Querschnitt in Fig. 1 dargestellt ist. Diese Elektronenkanone 17 ist auf dem Sockel 18 mittels der zwei Stecker aufgesteckt. Das Gehäuse ist durch die Trennwand 19 unterteilt. Die Trennwand 9 weist mittig eine Öffnung 20 für den Durchtritt des Elektronenstromes 21 auf. An dem Gehäuseteil 16, das auch den Evakuierungsstutzen 22 trägt, mit dem die gesamte Röntgenröhre für den Begrieb evakuiert wird, ist der Gehäuseteil 15 angeflanscht. In diesem befinden sich Ablenk- und Fokussierspulen 23, 24, 25 und auf eine stirnseitige Öffnung ist der das Target 26 aufnehmende Gehäuseteil 27 angebracht. Dieser Gehäuseteil weist ein Austrittsfenster 28 für die am Target 26 erzeugte Röntgenstrahlung auf. Im Strahlungsfeld dieses Röntgenfensters 28 ist ein Träger mit der Lithographiemaske 29 sowie ein Träger mit dem zu bestrahlenden Substrat angeordnet. Bei diesem Substrat handelt es sich um einen Chip für elektronische Schaltungen.

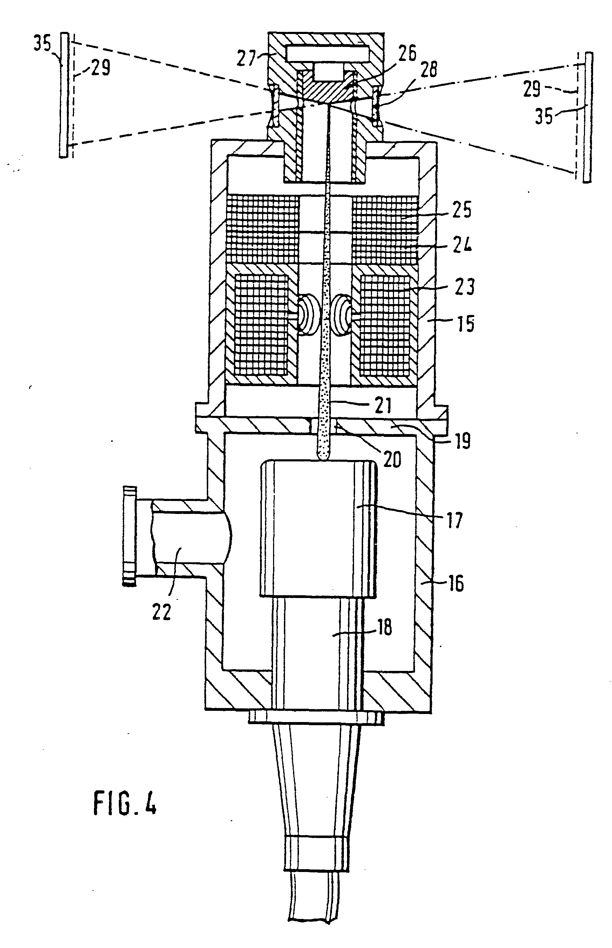

In Fig. 3 ist in Vergrößerung ein Querschnitt durch den Gehäuseteil 27 mit dem Target 26 dargestellt. Die gestrichelte Linie 30 liegt in der geometrischen Mitte der Röntgenröhre und geht durch den Zenit der gewölbten Fläche 31 des Targets 26. Der Elektronenstrom 21 verläuft versetzt zu der Linie 30 und fällt unter einem Targetwinkel von 0 bis 10° auf die Oberfläche 31 des Targets 26 und erzeugt hier die Röntgenstrahlung 33, die durch das Fenster 28 ausfällt. Der Innenraum des Gehäuseteiles 27 ist mit einer Röntgenstreustrahlung absorbierenden Auskleidung 34 versehen.

In dieser Röntgenröhre kann der Elektronenstrom 21 von der Teilfläche 31 A durch elektronische Ablenkung über den Zenit 31 B auf die Teilfläche 31 C gelenkt werden, von wo die dort erzeugte Röntgenstrahlung nicht durch das Austrittsfenster 28 austritt. Dieses erfolgt bei einem Wechsel der dicht neben dem Zenit 35 B liegenden Abstrahlorte auf dem Target 26. Dieser Wechsel erfolgt, damit das Target nicht an einzelnen Punkten überhitzt und dadurch beschädigt wird. Um von einem Abstrahlpunkt, z. B. dem in der Papierebene liegenden Abstrahlpunkt, zu einem anderen Abstrahlpunkt, der vor oder hinter der Papierebene gelegen ist, zu gelangen, läßt man den Elektronenstrom zweimal den Zenit 36 B überschreiten und einen großen Teil des Weges von einem Abstrahlpunkt zum nächsten auf der dem Fenster 28 abgewandten Seite des Targets verlaufen. Hierdurch werden Verwischungseffekte auf dem Substrat vermieden.

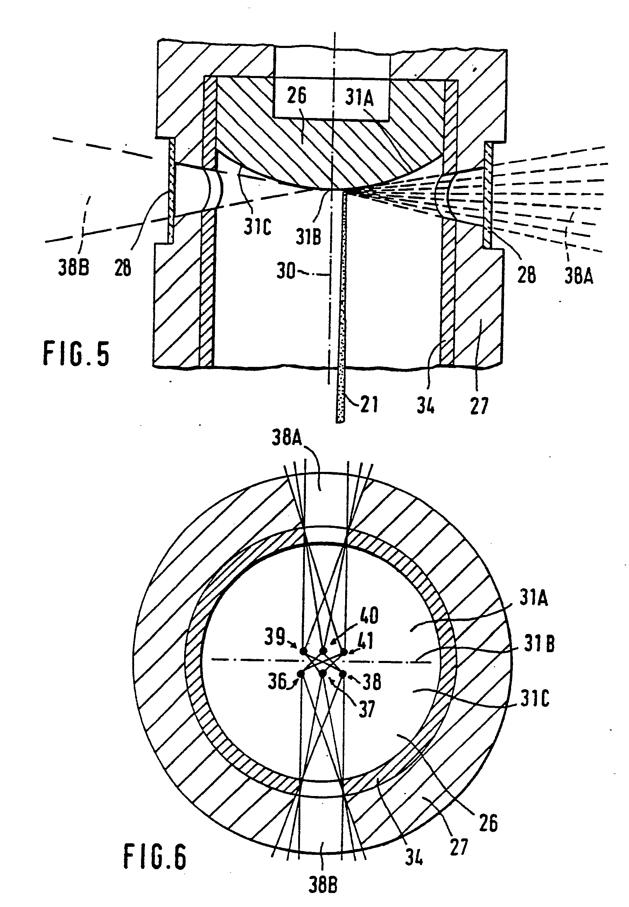

Diese gewölbte Ausbildung des Targets und die Ablenkung des Elektronenstromes von einer Targetfläche 31 A auf die andere Targetfläche 31 C kann aber auch ausgenutzt werden, um im Impulsbetrieb zwei Substrate 35 wechselweise mit Röntgenstrahlung zu bestrahlen. Eine hierfür geeignete Vorrichtung ist in Fig. 4 dargestellt. Sie weist den gleichen Aufbau wie die Vorrichtung der Fig. 2 auf, hat lediglich zu beiden Seiten des Gehäuseteiles 27 je einen Träger für eine Lithographiemaske 99 und je einen Träger für ein Susbtrat 35 aufzuweisen. Darüber hinaus hat der Gehäuseteil 27 nicht ein Austrittsfenster 28, sondern zwei Austrittsfenster 28 A, 28 B, wie das auch aus Fig. 5 ersichtlich ist.

In Fig. 6 ist ein Schnitt durch den Gehäuseteil 27 gezeigt, bei dem man auf das Target 26 schaut. Zu beiden Seiten des Zenits 31 sind je drei Abstrahlpunkte 36, 37, 38 auf der Teilfläche 31 A und 39, 40, 41 auf der Teilfläche 31 C angeordnet. Wie durch die gestrichelten Pfeillinien angedeutet, wandert der Abstrahlpunkt vom Ort 36 nach Abstrahlort 40, dann nach Abstrahlort 38, dann nach Abstrahlort 39, dann nach Abstrahlort 37, dann nach Abstrahlort 41 und von dort wieder zurück zum Abstrahlort 36. Bei jeder dieser Wanderungen von einem Abstrahlort zum anderen wird der Zenit 31 B überschritten. Jedes der beiden Substrate 35 wird somit für eine bestimmte Zeit bestrahlt, dann wird es ausgewechselt gegen ein unberstrahltes Substrat, wenn der Röntgenstrahl auf ein anderes Susbtrat gerichtet ist, und danach wird das unbestrahlte Substrat von einem anderen Fleck der gleichen Targetfläche bestrahlt. Im gezeichneten Ausführungsbeispiel werden von den sechs Abstrahlpunkten sechs Substrate bestrahlt, ehe sich der Zyklus für die nächsten sechs Substrate wiederholt.

Eine Impulspause kann hier für die Auswechslung eines ausreichend bestrahlten Substrats gegen ein unbestrahltes Substrat genutzt werden. Hierdurch befindet sich die Röntgenröhre in Dauerbetrieb, ohne jegliche Ausfallzeit.

Zur Erzeugung der gewünschten langwelligen Strahlung verwendet man Beschleunigungsspannungen von 3 bis 25 KV und ein Target aus Wolfram. Durch Berechnung wählt man die Beschleunigungsspannung derart, daß die Abbremsung der Elektronen möglichst in der obersten Atomschicht erfolgt, so daß lediglich in den obersten Atomschichten nahezu der gesamte Elektronenstrom abgebremst ist.

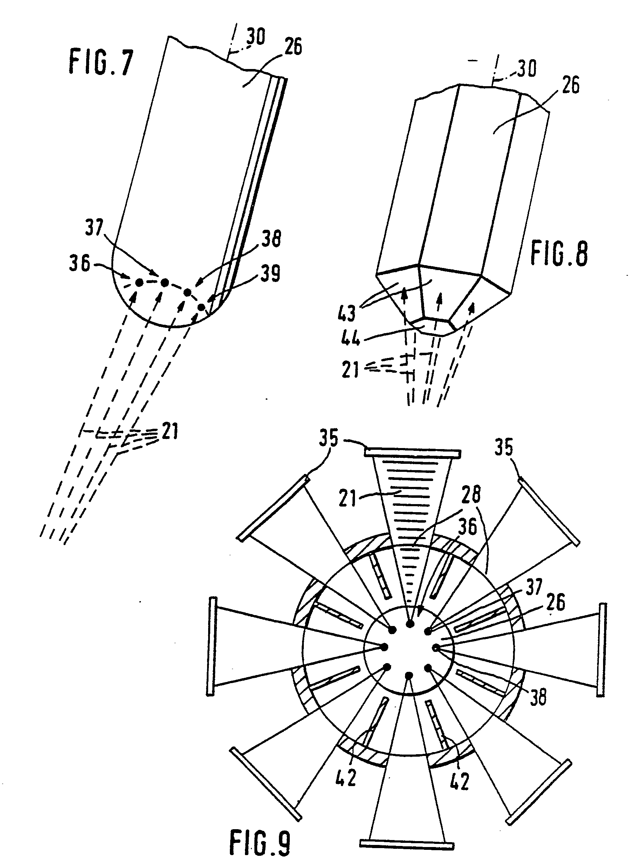

Fig. 7 zeigt ein gewälbtes Target, welches eine halbkugelförmig ausgebildete Abstrahlungsfläche aufweist. Von den Abstrahlungspunkten 36, 37, 38, 39 (und den nicht im Bild sichtbaren Abstrahlungspunkten 40, 41) werden Röntgenstrahlen in solche Richtungen ausgesandt, die in radialen Ebene zur geometrischen Achse 30 des Targets 26 liegen. Der Elektronenstrahl 21 wird dabei Schritt für Schritt von einem Abstrahlpunkt zum nächsten Abstrahlpunkt weiterbewegt, um dann immer eine gewisse Zeit auf dem Abstrahlpunkt zu verharren. Bei dieser Ausführungsform sind die zu bestrahlenden Substrate 35 radial um die geometrische Achse 30 des Targets angeordnet, wie dieses die Fig. 9 zeigt. Hier sind auf dem Target acht Abstrahlpunkte vorgesehen, auf die der Elektronenstrahl 21 durch elektromagnetische Ablenkung gelenkt wird und es sind entsprechend acht Austrittsfenster 28 vorgesehen, durch die jeweils der Röntgenstrahl 28 austritt. Zwischen den einzelnen Austrittsfenstern 28 sind Abschirmbleche 42 vorgesehen, die einen unerwünschten Austritt der Röntgenstrahlung aus benachbarten Austrittsfenstern 28 verhindern. Die Substrate 35 sind auf einer Kreislinie um die geometrische Achse 30 angeordnet, hierfür sind besondere Halterungen vorgesehen. Andere Halterungen haltern vor dem Susbtrat 35 je eine Lithographiemaske 29.

In Fig. 8 ist eine andere mögliche Targetform dargestellt, die sechs ebene Flächen 43 aufweist, auf die der Elektronenstrahl 21 gelenkt wird und auf diesen Flächen den Abstrahlpunkt 36 bis 41 bildet. Hier ist das Target somit pyramidenstumpfförmig ausgebildet, in der Mitte befindet sich eine Fläche 44, welche durch eine Kante von den Flächen 43 getrennt ist und die senkrecht zur geometrischen Achse des Targets liegt.

Natürlich braucht die Anzahl der Abstrahlpunkte und die Anzahl der Abstrahlflächen 43 nicht gradzahlig zu sein, auch ungradzahlige Anzahlen von Flächen und Abstrahlpunkten sind möglich. Wenn es räumliche äußere Bedingungen notwendig machen, ist es such nicht notwendig, daß die Substrate im Kreis um die Röntgenröhre angeordnet sind, sondern sie können auch auf einem Teilkreis angeordnet sein. Diese Anordnung mehrerer zu bestrahlender Substrate und die Ausnutzung eines einzigen Targets für die Bestrahlung verschiedener Substrate durch verschiedene Austrittsfenster an verschiedenen Orten ist nicht abhängig von der im Anspruch 1 beschriebenen Elektronenkanone, wenn diese nur einen ausreichend scharf gebündelten Elektronenstrahl von ausreichend hoher Intensität auf das Target schießt.

## Patentansprüche

1. Röntgenlithographiegerät, bestehend aus einer Röntgenröhre mit mindestens einem Austrittsfenster zur Erzeugung einer langwelligen Röntgenstrahlung, die eine aus Glühkathode und Gitter bestehende Elektronenkanone, eine Elektronenstrahlablenk- und -bündelungsvorrichtung, ein Target aus einem Material hoher Ordnungszahl und hohen Schmelzpunktes aufweist, aus einem Träger für das mit Röntgenstrahlen zu belichtende Substrat sowie aus einem Träger für die Lithographiemaske, dadurch gekennzeichnet, daß eine Elektronenkanone (17), bei der das Gitter (9) auf seiner dem Target (26) zugewandten Seite einen nach innen gerichteten Flansch (10) aufweist, der die Öffnung (11), in der sich die Spitze der Glühkathode (1) befindet, umschließt, bei der die der Glühkathode (1) zugewandte Seite (12) des Flansches (10) eben ist oder in Richtung auf die Glühkathode (1) abgewinkelt ist, bei der die dem Target zugewandte Seite (13) des Flansches (10) unter einem Winkel ß von 100° bis 140° in Richtung auf die Spitze der Glühkathode (1) zu verläuft, und bei der sich das Material des Flansches (10) in Richtung auf den die zentrische Öffnung (11) begrenzenden Rand (14) unter einem Winkel $\alpha$ von 15 bis 60° verjüngt, in der Röntgenröhre verwendet wird, daß der Brennfleck (36-41) auf dem Target (26) einen Durchmesser von weniger als $10^{-4}$ m aufweist, daß der Abstand zwischen dem Target (26) und dem Röntgenstrahlenaustrittsfenster (28) der Röntgenröhre maximal $2.10^{-2}$ m beträgt und daß der Abstand zwischen Target (26) und Lithographiemaske (29) maximal $2.10^{-1}$ m beträgt, daß die Oberfläche des Targets (26) aus einer gewölbten oder mindestens zwei, durch eine Kante voneinander getrennten winklig zueinander angeordneten ebenen Flächen besteht, daß ein Teil der gewölbten Fläche (31A) oder die eine ebene Fläche dem Röntgenstrahlenaustrittsfenster (28) zugewandt und der andere Teil (31C) der gewölbten Fläche oder die andere ebene Fläche dem Röntgenstrahlenaustrittsfenster (28) abgewandt ist, daß man für die durch jedes Austrittsfenster (28A, 28B) der Röntgenröhre austretenden Strahlen den Targetwinkel so wählt, daß er zwischen 0 und 10°, vorzugsweise bei 5,5°, liegt und daß eine Steuervorrichtung für die in die Ablenkvorrichtung (23) eingespeisten Spannungen vorgesehen ist, mit der der Elektronenstrom (21) bei der Wanderung von einem Abstrahlpunkt (36) auf einen anderen Abstrahlpunkt (40) zweimal über den der Elektronenkanone (17) zugewandten Zenit (31B) oder eine der Elektronenkanone (17) zugewandte Kante auf dem Target (26) abgelenkt wird.

2. Röntgenlithographiegerät nach Anspruch 1, dadruch gekennzeichnet, daß die Steuervorrichtung den Auftreffpunkt des Elektronenstrahles (21) auf einem Abstrahlpunkt (36) verharren läßt und dann den Elektronenstrahl (21) mit hoher Geschwindigkeit auf den nächsten Abstrahlpunkt (40) bewegt und ihn dort wieder verharren läßt.

3. Röntgenlithographiegerät nach Anspruch 1, dadurch gekennzeichnet, daß die Röntgenröhre auf mindestens zwei gegenüberliegenden Seiten je ein Röntgenstrahlenaustrittsfenster (28A, 28B) aufweist, zwischen denen das Target (26) angeordnet ist, daß die Oberfläche (31) des Targets (26) aus einer gewöhlbten Fläche mit der Elektronenkanone (17) zugewandtem Zenit (13B) oder aus mindestens zwei ebenen, durch eine Kante voneinander getrennten, winklig zueinander angeordneten ebenen Flächen besteht, daß beidseits des Zenits (31B) je ein Teil (31A, 31B) der gewölbten Fläche (31) oder beidseits der Kante je eine ebene Fläche je einem Röntgenaustrittsfenster (28A, 28B) zugewandt ist, daß man für die durch jedes Austrittsfenster (28A, 28B) der Röntgenröhre austretenden Strahlen den Targetwinkel so wählt, daß er zwischen 0 und 10°, vorzugsweise bei 5,5°, liegt und daß eine Steuervorrichtung für die in die Ablenkvorrichtung (23) eingespeisten Spannungen vorgesehen ist, mit der der Elektronenstrom (21) bei der Wanderung von einem Abstrahlpunkt (36) auf einer Fläche (bzw. Flächenteil 31A) auf einen anderen Abstrahlpunkt (40) auf der anderen Fläche (bzw. Flächenteil 31C) über den Zenit (31B) oder die Kante abgelenkt wird.

4. Röntgenlithographiegerät nach Anspruch 3, dadurch gekennzeichnet, daß das Target die Form einer Halbkugel, eines Kegels, eines Kegelstumpfes, einer Pyramide mit mindestens drei Seiten oder eines Pyramidenstumpfes mit mindestens drei Pyramidenflächen aufweist, daß mehrere Austrittsfenster für die Röntgenstrahlen vorgesehen sind und daß um die Röntgenröhre herum eine der Anzahl der Röntgenfenster entsprechende Anzahl von Halterungen für die Substrate (35) und Halterungen für die Lithographiemasken vorgesehen sind.

5. Röntgenlithographiegerät nach Anspruch 3 oder 4, dadurch gekennzeichnet, daß zwischen den einzelnen Austrittsfenstern (28) für die Röntgenstrahlen in radialer Anordnung Abschirmbleche (42) gegen seitliche Strahlung vorgesehen sind.

**Claims**

1. An X-ray lithographic apparatus comprising an X-ray tube having at least one outlet window for the generation of long-wave X-radiation which is provided with an electron gun formed by a hot cathode and a grid, an electric beam deflecting and focusing device, and a target made of a material having a high atomic number and a high melting point, and comprising a carrier for the substrate which is to be irradiated with X-rays and comprising a carrier for the lithographic mask, characterised in that in the X-ray tube an electron gun (17), is used, wherein the grid (9) is provided on its side facing the target (26) with an inwardly-directed flange (10) which surrounds the opening (11) in which the tip of the hot cathode (1) is located, wherein that side (12) of the flange (10) facing the hot cathode (1) is flat or is bent at an angle in the direction of the hot cathode (1), wherein that side (13) of the flange (10) facing the target extends at an angle β of 100° to 140° in the direction of the tip of the hot cathode (1) and wherein the material of the flange (10) tapers at an angle α of 15° to 60° in the direction of the edge (14) which delimits the central opening, in that the focal point (36 to 41) on the target (26) has a diameter of less than $10^{-4}$ m, in that the distance between the target (26) and the X-ray outlet window (28) of the X-ray tube amounts at the maximum to $2.10^{-2}$ m and that the distance between the target (26) and the lithographic mask (29) amounts at the maximum to $2.10^{-1}$ m, in that the surface of the target (26) comprises one curved surface or at least two flat surfaces which are separated from one another by an edge and which are arranged at an angle to one another, in that a part of the curved surface (31A) or one of the flat surfaces faces towards the X-ray outlet window (28) and the other part (31C) of the curved surface or the other flat surface faces away from the X-ray outlet window (28), in that the target angle for the rays emitted from each outlet window (28A, 28B) of the X-ray tube is selected to be such that it amounts to between 0° and 10°, preferably 5.5° and in that a control device is provided for the voltage fed into the deflecting device (23), by means of which control device the electron current (21) in travelling from one radiating point (36) to another radiating point (40), is deflected twice over the zenith (31B) facing the electron gun (17) or an edge facing the electron gun (17) on the target (26).

2. An X-ray lithographic apparatus as claimed in claim 1, characterised in that the control device causes the point of impact of the electron beam (21) to remain at one radiating point (36) and then moves the electron beam (21) at high speed towards the next radiating point (40) and causes it to remain again at this point.

3. An X-ray lithographic apparatus as claimed in claim 1, characterised in that on at least two opposite sides the X-ray tube is provided with a respective X-ray outlet window (28A, 28B), between which the target (26) is arranged, that the surface (31) of the target (26) comprises one curved surface having a zenith (13B) facing towards the electron gun (17) or at least two flat surfaces which are separated from one another by an edge and are arranged at an angle to one another, that on both sides of the zenith (31B) a respective part (31A, 31B) of the curved surface (31), or on both sides of the edge a respective flat surface in each case faces towards a respective X-ray outlet window (28A, 28B), that the target angle for the rays emitted through each outlet window (28A, 28B) of the X-ray tube is selected to be such that it amounts to between 0° and 10°, preferably 5.5° and that a control device is provided for the voltages fed into the deflecting device (23), with which control device the electron current (21), in travelling from one radiating point (26) on one surface (or surface part 31A) to another radiating point (40) on the other surface (or surface part 31C), is deflected over the zenith (31B) or the edge.

4. An X-ray lithographic apparatus as claimed in claim 3, characterised in that the target has the form of a hemisphere, a cone, a truncated cone, a pyramid having at least three sides or a truncated pyramid having at least three pyramid surfaces, that a plurality of outlet windows are provided for the X-rays and that around the X-ray tube are arranged a number, (corresponding to the number of X-ray windows), of supports for the substrates (35) and supports for the lithographic masks.

5. An X-ray lithographic apparatus as claimed in claim 3 or claim 4, characterised in that between the individual outlet windows (28) for the X-rays, screening plates (42) are arranged radially as a protection against lateral radiation.

## Revendications

1. Appareil de lithographie par rayons X, se composant d'un tube à rayons X avec au moins une fenêtre de sortie pour la production d'un rayonnement X à ondes longues, qui comprend un canon électronique se composant d'une cathode à incandescence et d'une grille, un dispositif de déviation et concentration de rayonnement électronique, une cible formée d'un matériau de grand nombre atomique et de point de fusion élevé, l'appareil comprenant également un support pour le substrat à irradier par les rayons X et un support pour le masque lithographique et étant caractérisé en ce que dans le tube à rayons X est utilisé un canon électronique (17), dans lequel la grille (9) comporte, sur son côté dirigé vers la cible (26), une collerette (10) orientée vers l'intérieur et entourant l'ouverture (11) où se trouve la pointe de la cathode à incandescence (1), dans lequel le côté (12), dirigé vers la cathode à incandescence (1), de la collerette (10) est plan ou plié en direction de la cathode à incandescence (1), dans lequel le côté (13), dirigé vers la cible, de la collerette (10) fait un angle β compris entre 100° et 140° en direction de la pointe de la cathode à incandescence (1) et dans lequel le matériau de la collerette (10) est effilé selon un angle α de 15 à 60° en direction du bord (14) délimitant l'ouverture centrale (11), en ce que le foyer (36-41) sur la cible (26) a un diamètre inférieur à $10^{-4}$ m, en ce que l'espacement entre la cible (26) et la fenêtre (28) de sortie de rayons X du tube à rayons X s'élève au maximum à $2.10^{-2}$ m, en ce que l'espacement entre la cible (26) et le masque lithographique (29) s'élève au maximum à $2.10^{-1}$ m, en ce que la surface de la cible (26) se compose d'une surface bombée et d'au moins deux surfaces planes, inclinées l'une par rapport à l'autre et séparées l'une de l'autre par une arête, en ce qu'une partie de la surface bombée (31A) ou bien une des surfaces planes est dirigée vers la fenêtre (28) de sortie de rayons X et l'autre partie (31C) de la surface bombée ou bien l'autre surface plane est opposée à la fenêtre (28) de sortie de rayons X, en ce qu'on choisit, pour les rayons sortant de chaque fenêtre de sortie (28A, 28B) du tube à rayons X, l'angle de cible de manière qu'il soit compris entre 0 et 10°, en étant de préférence de 5,5°, et en ce qu'il est prévu un dispositif de commande des tensions appliquées au dispositif de déviation (23) à l'aide duquel le courant d'électrons (21) est dévié, lors du passage d'un point d'irradiation (36) à un autre point d'irradiation (40), deux fois sur le zénith (31B) dirigé vers le canon électronique (17) ou bien sur un bord de la cible (26) qui est dirigé vers le canon électronique (17).

2. Appareil de lithographie par rayons X selon la revendication 1, caractérisé en ce que le dispositif de commande permet d'arrêter le point d'impact du rayon électronique (21) sur un point d'irradiation (36) et ensuite il déplace le rayon électronique (21) à grande vitesse jusqu'au point d'irradiation suivant (40) en lui permettant à nouveau de rester sur celui-ci.

3. Appareil de lithographie par rayons X selon la revendication 1, caractérisé en ce que le tube à rayons X comporte, sur au moins deux côtés mutuellement opposés, respectivement une fenêtre (28A, 28B) de sortie de rayons X, la cible (26) étant disposée entre les fenêtres précitées, en ce que la surface (31) de la cible (26) se compose d'une surface bombée dont le zénith (13B) est dirigé vers le canon électronique (17), ou bien d'au moins deux surfaces planes, inclinées l'une par rapport à l'autre et séparées l'une de l'autre par une arête, en ce que, des deux côtés du zénith (31B) respectivement une partie (31A, 31B) de la surface bombée (31), ou bien des deux côtés de l'arête précitée respectivement une surface plane est dirigée vers une fenêtre respective de sortie de rayons X (28A, 28B), en ce qu'on choisit, pour les rayons sortant de chaque fenêtre de sortie (28A, 28B) du tube à rayons X un angle de cible de telle sorte qu'il soit compris de préférence entre 0 et 10° en étant avantageusement de 5,5° et en ce qu'il est prévu un dispositif de commande des tensions appliquées au dispositif de déviation (23) à l'aide duquel le courant d'électrons (21) est dévié, lors du passage d'un point d'irradiation (36) se trouvant sur une surface (ou une partie de surface 31A) jusqu'à un autre point d'irradiation (40) se trouvant sur l'autre surface (ou la partie de surface 31C), sur le zénith (31B) ou l'arête.

4. Appareil de lithographie par rayons X selon la revendication 3, caractérisé en ce que la cible a la forme d'une hémisphère, d'un cône, d'un tronc de cône, d'une pyramide comportant au moins trois côtés ou d'un tronc de pyramide comportant au moins trois surfaces de pyramide, en ce que plusieurs fenêtres de sortie sont prévues pour les rayons X et en ce qu'il est prévu, autour du tube à rayons X, un nombre de supports pour les substrats (35) et de supports pour les masques lithographiques qui correspond au nombre de fenêtres de sortie de rayons X.

5. Appareil de lithographie par rayons X selon une des revendications 3 ou 4, caractérisé en ce qu'il est prévu entre les différentes fenêtres de sortie (28) de rayons X des tôles (42) d'arrêt de rayonnement latéral qui sont disposées radialement.

FIG.1

FIG.3

FIG.2

FIG.4

FIG.5

26 | 31A

31C 31B

30~

38B 28

28 38A

21 34 27

38A

40
39~ 41
36 38
37

31A

31B

31C

26

34 27

FIG.6

38B

4

FIG.7

FIG.8

FIG.9